# EUROPÄISCHE PATENTSCHRIFT

(11) **EP 2 961 558 B1**
(45) Veröffentlichungstag und Bekanntmachung des Hinweises auf die Patenterteilung: **23.11.2016**
(21) Anmeldenummer: 14700638.1
(22) Anmeldetag: 15.01.2014
(51) Int. Cl.: B23K 20/00, H01M 2/20, H01M 10/42, H01M 10/48, B60L 11/18, B60L 1/02, B60L 3/00, H01L 23/00, B23K 101/38, H01L 23/367

(54) **HOCHVOLT-ENERGIESPEICHERMODUL UND VERFAHREN ZUR HERSTELLUNG DES HOCHVOLT-ENERGIESPEICHERMODULS**
HIGH-VOLTAGE ENERGY STORAGE MODULE AND METHOD FOR PRODUCING THE HIGH-VOLTAGE ENERGY STORAGE MODULE
MODULE D'ACCUMULATION D'ÉNERGIE À HAUTE TENSION ET PROCÉDÉ DE FABRICATION DU MODULE D'ACCUMULATION D'ÉNERGIE À HAUTE TENSION

(30) Priorität: 27.02.2013 DE 102013203280
(43) Veröffentlichungstag der Anmeldung: 06.01.2016
(73) Patentinhaber: Bayerische Motoren Werke Aktiengesellschaft, 80809 München (DE)
(72) Erfinder: GAUBATZ, Karl-Heinz, 85599 Parsdorf (DE); LOPEZ DE ARROYABE, Jose, 81541 München (DE)
(86) Internationale Anmeldenummer: PCT/EP2014/050644
(87) Internationale Veröffentlichungsnummer: WO 2014/131541

(56) Entgegenhaltungen:
- JP-A- 2010 282 811
- US-A1- 2007 188 147
- US-A1- 2008 241 667
- US-A1- 2012 141 852

## Beschreibung

Vorliegende Erfindung betrifft ein Hochvolt-Energiespeichermodul für eine Spannungsversorgung, insbesondere eines Kraftfahrzeugs, sowie ein Verfahren zur Herstellung des Hochvolt-Energiespeichermoduls.

Hochvolt-Energiespeichermodule werden in Fahrzeugen zum alleinigen oder ergänzenden Antrieb des Fahrzeugs über einen Elektromotor eingesetzt. Dabei können mehrere der Hochvolt-Energiespeichermodule zu einer Batterie zusammengefasst werden. Die einzelnen Hochvolt-Energiespeichermodule weisen mehrere aneinandergereihte Speicherzellen auf. In den einzelnen Speicherzellen befinden sich elektrochemische Elemente, beispielsweise ausgebildet als Lithium-Ionen-Akkumulatoren. Im Stand der Technik werden die einzelnen Pole der Speicherzellen im Hochvolt-Energiespeichermodul untereinander mittels Kabel oder starren Zellerbindern verbunden.

Bei solchen Hochvolt-Energiespeichermodulen ist zudem der Einsatz von Bonddrahtverbindungen bekannt. Allerdings nicht dafür, einzelne Batteriepole der Speicherzellen untereinander zu verbinden, sondern dafür, einzelne Batteriepole mit anderen in einem Hochvolt-Energiespeichermodul enthaltenen Komponenten zu verbinden. So ist beispielsweise in der JP 2010282811 A1 ein Hochvolt-Energiespeichermodul beschrieben, das aus einer Vielzahl von Speicherzellen aufgebaut ist, von denen jede zwei Batteriepole aufweist. Für jede dieser Speicherzellen sind der eine Batteriepol über erste Bonddrähte mit einer ersten Verbindungsplatte und der andere Batteriepol über zweite Bonddrähte mit einer zweiten Verbindungsplatte verbunden. In der US 2007/0188147 A1 ist ein aus wiederaufladbaren Speicherzellen aufgebautes Energiespeichermodul beschrieben. Die positiven Speicherzellenterminals sind jeweils über einen ersten Bonddraht mit einem ersten Stromleiter und die negativen Speicherzellenterminals jeweils mit einem zweiten Bonddraht mit einem zweiten Stromleiter verbunden. Die Bonddrähte sind dabei so ausgelegt, dass der bei einem normalen Betriebszustand einer Speicherzelle entnommene oder dieser zugeführte Strom durch den Bonddraht fließen kann, ohne diesen signifikant zu erwärmen, wobei die Bonddrähte im Falle eines Kurzschlusses durch den dabei fließenden Strom zerstört werden. Aus der US 2008/0241667 A1 ist ein Energiespeichermodul bekannt, das aus einer Vielzahl von Energiespeicherzellen aufgebaut ist. Jede Energiespeicherzelle weist zwei Anschlussterminals auf, wobei eines dieser beiden Terminals mittels eines ersten Bonddrahts mit einer ersten Leiterplatte und das andere Terminal mittels eines zweiten Bonddrahts mit einer zweiten Leiterplatte verbunden sind. Die Bonddrähte sind dabei so ausgelegt, dass diese bei Überschreiten einer vorgegebenen Kraft oder eines thermischen Parameters zerstört werden, um dadurch einen weiteren Stromfluss zu unterbinden. Aus der US 2012/0141852 A1 ist ein Energiespeichermodul bekannt, das aus einer Vielzahl von Energiespeicherzellen aufgebaut ist. Das Modul weist eine Leiterplatte auf, mit der jeweils ein Terminal der Energiespeicherzellen mittels eines Bonddrahtes verbunden ist. Die Bonddrähte sind dabei derart dimensioniert, dass zum einen die an den ihnen abfallende Verlustleistung gering ist und dass zum anderen der Bonddraht durchbrennt, wenn durch ihn Strom fließt, der größer als ein vorgegebener Strom ist.

Es ist Aufgabe vorliegender Erfindung, ein Hochvolt-Energiespeichermodul anzugeben, das kostengünstig und in einem automatisierten Prozess herstellbar ist. Ferner soll das Hochvolt-Energiespeichermodul betriebssicher und wartungsarm funktionieren. Des Weiteren ist es Aufgabe vorliegender Erfindung, ein entsprechendes Verfahren zum Herstellen des Hochvolt-Energiespeichermoduls anzugeben.

Die Aufgabe wird gelöst durch die Merkmale der beiden unabhängigen Ansprüche. Die abhängigen Ansprüche haben jeweils vorteilhafte Weifergestaltungen der Erfindung zum Gegenstand.

Somit wird die Aufgabe gelöst durch ein Hochvolt-Energiespeichermodul für eine Spannungsversorgung, insbesondere eines Kraftfahrzeugs, umfassend zumindest zwei Speicherzellen und zumindest eine elektrisch leitende Verbindung zwischen zwei Polen unterschiedlicher Speicherzellen. In den Speicherzellen befinden sich elektrochemische Elemente, vorzugsweise ausgebildet als Lithium-Ionen-Akkumulatoren. Die Speicherzellen umfassen bevorzugt ein dichtes Gehäuse, in dem die elektrochemischen Elemente angeordnet sind. Auf jeder Speicherzelle sind zwei Pole ausgebildet. Die Pole werden auch als Anschlussterminals bezeichnet. Mittels der elektrisch leitenden Verbindung sind die Pole verschiedener Speicherzellen entweder parallel oder in Reihe miteinander verbunden. Erfindungsgemäß ist vorgesehen, dass die einzelne Verbindung aus mehreren nebeneinander angeordneten Bonddrähten besteht. Ein jeder Bonddraht ist dabei an den beiden Polen mittels Drahtbonden befestigt. Das Drahtbonden ist ein Verfahren zum Verbinden eines Drahtes mit einer Kontaktoberfläche, beispielsweise dem Pol der Speicherzelle. Das Drahtbonden wird auch als Mikroschweißen bezeichnet. Es bedarf dabei keines Schweißzusatzstoffes und keines Lotes. Zum Herstellen der Verbindung wird ein Teil des Bonddrahtes angeschmolzen. Dies erfolgt beispielsweise durch eine Aufbringung von Ultraschallschwingungen auf den Bonddraht.

Durch die Verwendung von drahtgebondeten Bonddrähten als elektrische Verbindung zwischen den einzelnen Polen, kann das Hochvolt-Energiespeichermodul in einem automatischen Fertigungsprozess hergestellt werden. Dadurch reduzieren sich die Kosten für das Hochvolt-Energiespeichermodul. Gleichzeitig sind die Bonddrähte relativ leicht, so dass Gewicht eingespart werden kann. Die Bonddrähte leiten den Hauptstrom, beispielsweise in einer Größenordnung von 200 A. Deshalb werden entsprechend viele Bonddrähte für eine Verbindung zwischen zwei Polen verwendet, um insgesamt einen entsprechend großen Leiterquerschnitt zur Verfügung zu stellen. Die einzelnen Bonddrähte sind relativ dünn und biegbar, so dass eine flexible Verbindung entsteht, die eine gewisse Längenausdehnung zwischen den Speicherzellen kompensieren kann und unanfällig gegenüber Belastungen, wie beispielsweise Vibrationen, ist.

) Bevorzugt umfasst das Hochvolt-Energiespeichermodul eine Platine mit einer Elektronik zum Überwachen der Speicherzellen. Mittels dieser Elektronik, vorzugsweise umfassen eine CPU, kann die Zellspannung und/oder Temperatur der einzelnen Speicherzellen überwacht werden. Die Platine ist bevorzugt auf die Speicherzellen aufgesetzt. Durch eine entsprechende Ausgestaltung der Platine, kann diese gleichzeitig zum Zentrieren und/oder Fixieren der einzelnen Speicherzellen untereinander genutzt werden. Dadurch können zusätzliche Bauteile eingespart werden.

Damit die Elektronik auf der Platine die Temperatur und/oder die Zellspannung der einzelnen Speicherzelle überwachen kann, bedarf es einer elektrischen Verbindung zur Platine, um einen Messstrom zu übertragen. Deshalb ist bevorzugt vorgesehen, dass zumindest einer der Bonddrähte zwischen den beiden Polen auf der Platine mittels Drahtbonden befestigt ist. Der entsprechende Bonddraht führt somit von einem Pol zur Platine und von der Platine zum nächsten Pol. Insbesondere ist der Bonddraht auf der Platine nicht unterbrochen, sondern lediglich mittels Drahtbonden angebunden.

Alternativ oder zusätzlich zu dem Anbinden des Bonddrahtes zwischen den beiden Polen, ist bevorzugt ein Zusatzbonddraht vorgesehen. Der Zusatzbonddraht wird mit einem Ende am Pol befestigt und mit dem anderen Ende auf der Platine. Die Befestigung am Pol und auf der Platine erfolgt wiederum mittels Drahtbonden.

Die Stelle, an der der Bonddraht oder der Zusatzbonddraht mit der Platine elektrisch leitend verbunden ist, wird als Befestigungsstelle bezeichnet. Bevorzugt ist in der Nähe der Befestigungsstelle ein Temperatursensor auf der Platine angeordnet. Der Temperatursensor ist dazu ausgebildet, die über den Bonddraht oder den Zusatzbonddraht weitergeleitete Temperatur der Speicherzelle zu bestimmen. Um die korrekte Temperatur der Speicherzelle zu ermitteln, wird bevorzugt ein entsprechendes Berechnungsmodell in die Elektronik auf der Platine implementiert. Mittels dieses Berechnungsmodells kann eine Phasenverschiebung zwischen der gemessenen Temperatur und der tatsächlichen Temperatur an der Speicherzelle berücksichtigt werden.

Die Platine ist relativ dünn ausgestaltet und umfasst vorzugsweise eine Kupferschicht im Bereich von 10 bis 100 µm. Deshalb ist für die elektrische Anbindung des gesamten Hochvolt-Energiespeichermoduls bevorzugt vorgesehen, dass auf der Platine ein Metallelement positioniert wird. Dieses Metallelement ist vorzugsweise eine Aluminiumplatte. Auf dem Metallelement . ist eine Anschlussvorrichtung für ein Kabel vorgesehen. Vorzugsweise ist die Anschlussvorrichtung zum Anschrauben eines Kabelschuhs ausgebildet. Des Weiteren ist eine elektrisch leitende Anschlussverbindung zwischen einem der Pole und dem Metallelement vorgesehen. Diese Anschlussverbindung besteht wieder aus mehreren nebeneinander angeordneten Bonddrähten. Jeder dieser Bonddrähte ist am Pol und am Metallelement mittels Drahtbonden befestigt.

Die Bonddrähte werden so dimensioniert, dass sie drahtgebonded werden können und ohne weiteres in die benötigte Form biegbar sind. Hierzu ist bevorzugt vorgesehen, dass die Bonddrähte einen runden Querschnitt mit einem Durchmesser von maximal 1 mm, vorzugsweise maximal 750 um, besonders vorzugsweise maximal 500 µm, aufweisen. Alternativ dazu sind die Bonddrähte bandförmig ausgestaltet und weisen vorzugsweise eine Breite von maximal 3 mm, besonders vorzugsweise maximal 2 mm, auf. Die Bonddrähte werden vorteilhafterweise aus Kupfer oder Gold, besonders vorzugsweise aus Aluminium, gefertigt.

Die Erfindung umfasst des Weiteren ein Verfahren zur Herstellung des Hochvolt-Energiespeichermoduls, umfassend die folgenden Schritte: (i) Bereitstellen zumindest zweier Speicherzellen, und (ii) Ausbilden zumindest einer elektrisch leitenden Verbindung zwischen zwei Polen unterschiedlicher Speicherzellen. Erfindungsgemäß werden für die einzelnen Verbindungen jeweils mehrere Bonddrähte verwendet, die Bonddrähte jeweils mit den beiden Polen drahtgebonded werden.

Die Unteransprüche und die vorteilhaften Ausgestaltungen des erfindungsgemäßen Hochvolt-Energiespeichermoduls finden entsprechend vorteilhafte Anwendung für das erfindungsgemäße Verfahren.

Insbesondere ist vorgesehen, dass beim Drahtbonden der Bonddraht durch Aufbringen von Druck und/oder Ultraschall und/oder erhöhter Temperatur mit dem jeweiligen Pol, mit dem Metallelement oder mit der Platine verbunden wird. Entsprechend wird auch der Zusatzbonddraht mit dem Pol und der Platine verbunden.

Bevorzugt wird zum Drahtbonden kein Zusatzwerkstoff, wie beispielsweise ein Schweißzusätz oder ein Lot, verwendet. Rein durch Aufbringen des Ultraschalls und/oder des Drucks und/oder der Temperatur wird der Bonddraht angeschmolzen und die leitende Verbindung hergestellt.

Weitere Einzelheiten, Merkmale und Vorteile der Erfindung ergeben sich aus der nachfolgenden Beschreibung und den Figuren. Es zeigen:
- Figur 1: ein erfindungsgemäßes Hochvolt-Energiespeichermodul gemäß einem ersten Ausführungsbeispiel,
- Figur 2: eine Speicherzelle des erfindungsgemäßen Hochvolt-Energiespeichermoduls gemäß dem ersten Ausführungsbeispiel,
- Figur 3: ein erstes Detail des erfindungsgemäßen Hochvolt-Energiespeichermoduls gemäß dem ersten Ausführungsbeispiel,
- Figur 4: ein zweites Detail des erfindungsgemäßen Hochvolt-Energiespeichermoduls gemäß dem ersten Ausführungsbeispiel,
- Figur 5: das erfindungsgemäße Hochvolt-Energiespeichermodul gemäß einem zweiten Ausführungsbeispiel,
- Figur 6: ein Detail des erfindungsgemäßen Hochvolt-Energiespeichermoduls gemäß dem zweiten Ausführungsbeispiel, und
- Figur 7: Herstellungsschritte für das Hochvolt-Energiespeichermodul beider Ausführungsbeispiele.

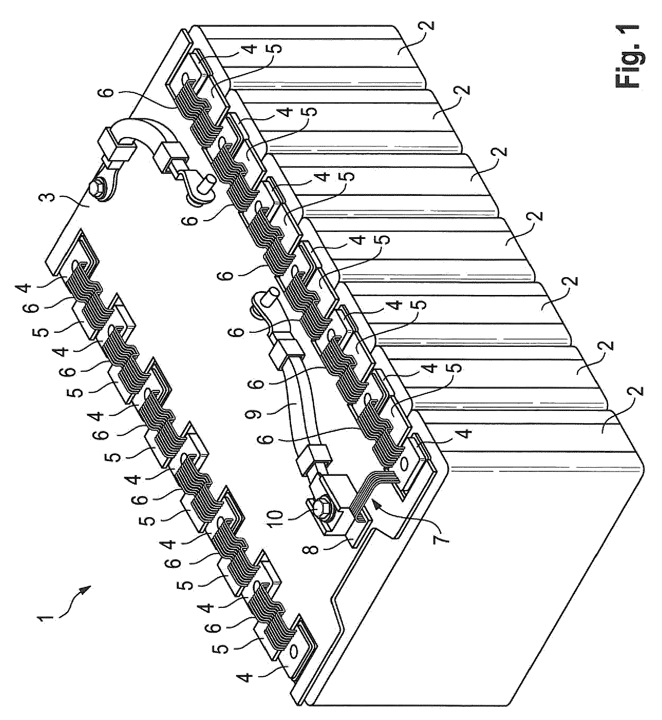

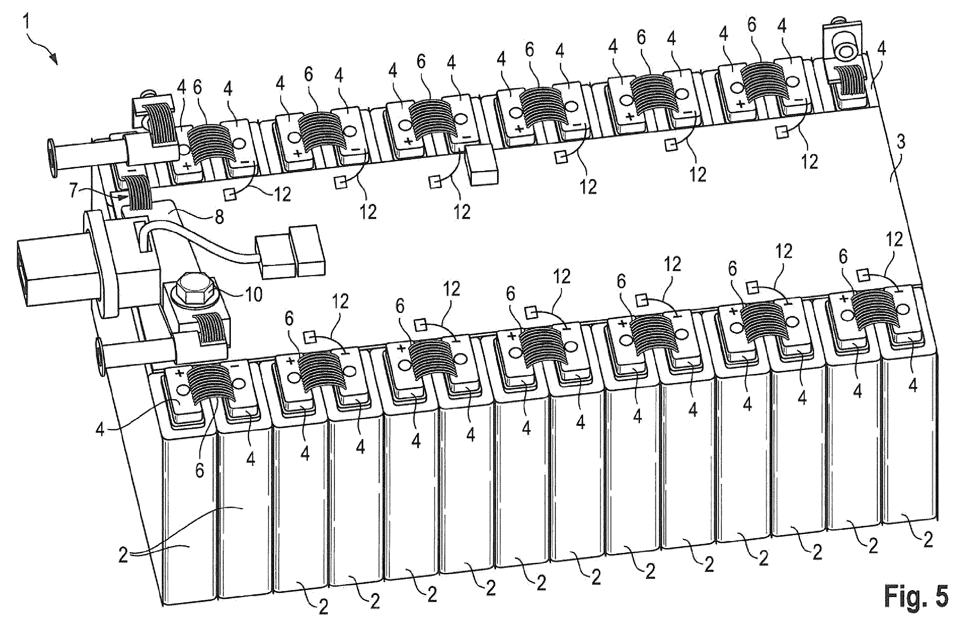

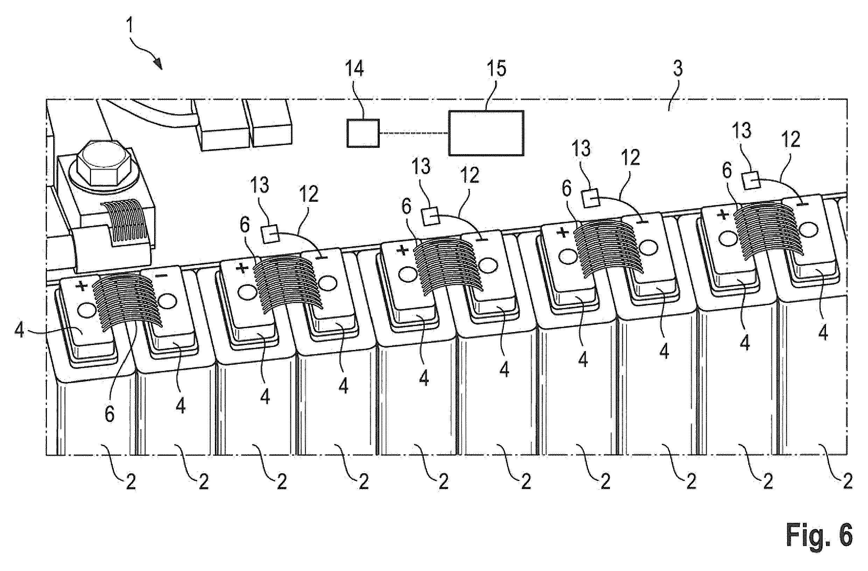

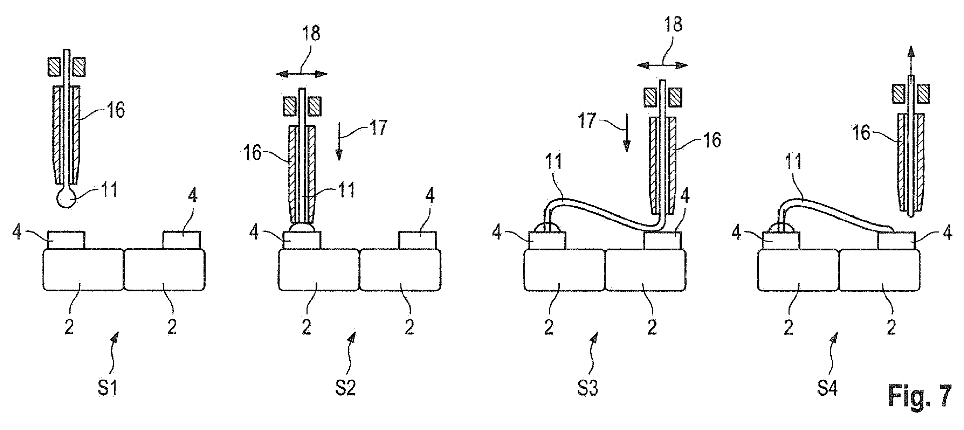

Im Folgenden wird anhand der Figuren 1 bis 4 ein erstes Ausführungsbeispiel des Hochvolt-Energiespeichermoduls 1 beschrieben. Figuren 5 und 6 zeigen ein zweites Ausführungsbeispiel des Hochvolt-Energiespeichermoduls 1. Figur 7 zeigt Verfahrensschritte zum Herstellen des Hochvolt-Energiespeichermoduls 1 beider Ausführungsbeispiele. Gleiche bzw. funktional gleiche Bauteile sind in allen Ausführungsbeispielen mit denselben Bezugszeichen versehen.

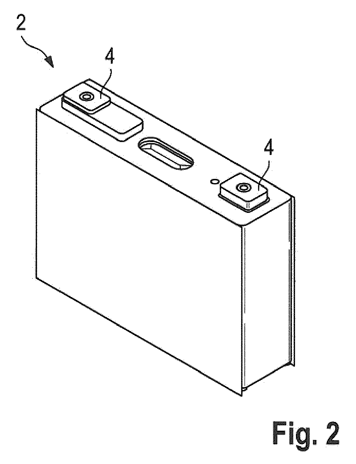

Gemäß Figur 1 umfasst das Hochvolt-Energiespeichermodul 1 mehrere Speicherzellen 2. Figur 2 zeigt eine der Speicherzellen 2 im Detail. Die Speicherzellen 2 sind prismatisch aufgebaut und im Hochvolt-Energiespeichermodul 1 aneinandergereiht. Jede Speicherzelle 2 weist zwei Pole 4 auf. Die Speicherzellen 2 sind so aneinandergereiht, dass alle Pole 4 zu einer Seite zeigen. Auf dieser Seite des Hochvolt-Energiespeichermoduls 1 ist eine Platine 3 aufgesetzt.

Die Platine 3 weist im ersten Ausführungsbeispiel mehrere Laschen 5 auf. Jeweils eine Lasche 5 ragt zwischen zwei benachbarte Pole 4 unterschiedlicher Speicherzellen 2. Die Platine 3 ist so ausgebildet, dass sie die Speicherzellen 2 untereinander positioniert und fixiert.

Jeweils zwischen zwei benachbarten Polen 4 unterschiedlicher Speicherzellen 2 ist eine Verbindung 6 angeordnet. Die Verbindung 6 ist elektrisch leitend und verbindet die unterschiedlichen Speicherzellen 2 in einer Reihen- oder Parallelschaltung miteinander.

Um das gesamte Hochvolt-Energiespeichermodul 1 mit einem weiteren Hochvolt-Energiespeichermodul 1 oder mit der Hochvolt-Stromversorgung eines Fahrzeugs zu verbinden, ist ein Kabel 9 vorgesehen. Um dieses Kabel 9 mit der Platine 3 zu verbinden, befindet sich auf der Platine 3 ein Metallelement 8. Auf dem Metallelement 8 ist eine Anschlussvorrichtung 10, beispielsweise zum Anschrauben eines Kabelschuhs des Kabels 9, ausgebildet. Das Metallelement 8 ist mittels einer Anschlussverbindung 7 mit einem der Pole 4 verbunden.

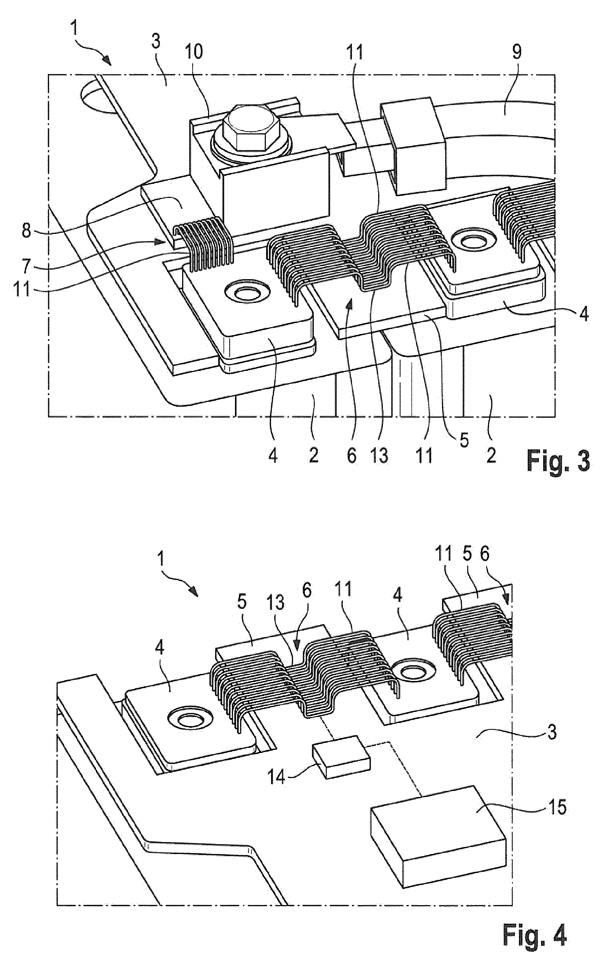

Figur 3 zeigt ein erstes Detail aus Figur 1. Die Verbindung 6 besteht aus mehreren nebeneinander angeordneten Bonddrähten 11. Die Bonddrähte 11 sind insbesondere parallel zueinander angeordnet und voneinander beabstandet. Die Bonddrähte 11 können auch übereinander angeordnet sein. Ein jeder Bonddraht führt von einem Pol 4 über die Platine 3 zum benachbarten Pol 4. Jeder Bonddraht 11 ist auf beiden Polen 4 und auf der Platine 3 mittels Drahtbonden befestigt und kontaktiert. Im gezeigten Beispiel sind elf Bonddrähte 11 für die Verbindung 6 gewählt. Entsprechend dem Querschnitt der einzelnen Bonddrähte 11 und dem maximalen Strom, wird die Anzahl der Bonddrähte 11 gewählt.

Des Weiteren zeigt Figur 3 die Anschlussverbindung 7. Auch die Anschlussverbindung 7 besteht aus einzelnen Bonddrähten 11. Die Bonddrähte 11 sind nebeneinander, insbesondere parallel zueinander, angeordnet. Jeder Bonddraht ist mittels Drahtbonden mit dem Metallelement 8 und dem Pol 4 verbunden.

Figur 4 zeigt ein zweites Detail aus Figur 1. Die Stelle, an denen die einzelnen Bonddrähte 11 der Verbindung 6 mit der Platine 3 verbunden sind, wird als Befestigungsstelle 13 bezeichnet. In der Nähe dieser Befestigungsstelle 13 befindet sich ein Temperatursensor 14 auf der Platine 3. Die Bonddrähte 11 leiten die Temperatur des Pols 4 und somit der Speicherzelle 2 auf die Platine 3. Auf der Platine 3 kann die entsprechende Temperatur mit dem Temperatursensor 14 erfasst werden. Etwaige Phasenverschiebungen oder Temperaturverluste zwischen dem Temperatursensor 14 und der Speicherzelle 2, werden durch ein entsprechendes Berechnungsmodell kompensiert. Hierzu ist der Temperatursensor 14 mit einer CPU 15 auf der Platine 3 verbunden. Die CPU 15 und der Temperatursensor 14 stehen im Allgemeinen für eine Elektronik, mittels derer die einzelnen Speicherzellen 2 überwacht werden können. Beispielsweise kann mit der CPU 15 und über die Befestigungsstelle 13 auch die Zellspannung in der einzelnen Zelle 2 gemessen werden.

Figuren 5 und 6 zeigen ein zweites Ausführungsbeispiel des Hochvolt-Energiespeichermoduls 1. Im Unterschied zum ersten Ausführungsbeispiel, ist im zweiten Ausführungsbeispiel vorgesehen, dass die Bonddrähte 11 der Verbindung 6 direkt von einem Pol 4 zum benachbarten Pol 4 verlaufen. Es entfällt dabei die Befestigungsstelle 13 zwischen den beiden Polen 4. Dadurch können die Pole 4 näher aneinander liegen. Für den Messstrom, ist an jeder Speicherzelle 2 ein Zusatzbonddraht 12 vorgesehen, der mit einem Ende am Pol 4 und mit dem anderen Ende auf der Platine 3 befestigt ist. Die Befestigung des Zusatzbonddrahtes 12 erfolgt wiederum über Drahtbonden. Insbesondere wird pro Speicherzelle 2 oder pro Pol 4 zumindest ein Zusatzbonddraht 12 eingesetzt. Die Anbindungsstelle des Zusatzbonddrahtes 12 auf der Platine 3 bildet wieder eine Befestigungsstelle 13, über die beispielsweise die Temperatur und/oder die Zellspannung gemessen werden kann.

Figur 7 zeigt Schritte S1 bis S4 zum Herstellen der Hochvolt-Energiespeichermodule 1 beider Ausführungsbeispiele. Gezeigt ist beispielhaft das Drahtbonden der Bonddrähte 11 zwischen zwei benachbarten Polen 4.

Figur 7 zeigt in Schritt S1, dass der Bonddraht 11 durch eine Kapillare 16 geführt ist. Das Ende des Bonddrahtes 11 wird zunächst auf einem Pol 4 positioniert. Gemäß Schritt S2 erfolgt sodann ein Aufbringen einer Ultraschallschwingung 18 auf den Bonddraht 11 und/oder auf die Kapillare 16. Gleichzeitig erfolgt ein Aufbringen einer Bondkraft 17, so dass sich der Bonddraht 11 mit dem Pol 4 verbindet. Danach wird die Kapillare 16 gemäß Schritt S3 zum benachbarten Pol 4 geführt. Durch die Bewegung der Kapillare 16 wird gleichzeitig der Bonddraht 11 in die richtige Form gebogen. Gemäß Schritt S3 erfolgt wiederum ein Aufbringen der Bondkraft 17 und der Ultraschallschwingung 18, so dass sich der Bonddraht 11 auch mit dem nächsten Pol 4 verbindet. Gemäß Schritt S4 erfolgt abschließend eine entsprechende Bewegung der Kapillare 16, so dass der Bonddraht 11 abgetrennt wird.

Bei der Ausbildung der Verbindung 6 gemäß dem ersten Ausführungsbeispiel wird die Kapillare 16 mit dem Bonddraht 11 zwischen den Schritten S2 und S3 auf der Platine 3 positioniert. Dabei erfolgt auch auf der Platine 3 eine Aufbringung der Ultraschallschwingung 18 und der Bondkraft 17. Allerdings wird der Bonddraht 17 bevorzugt nicht direkt nach der Verbindung mit der Platine 3 abgetrennt, sondern es erfolgt noch gemäß Schritt S4 die Verbindung zwischen dem Bonddraht 11 und dem nächsten Pol 4. Dadurch führt ein durchgehender Bonddraht 11 im ersten Ausführungsbeispiel von einem Pol 4 über die Platine 3 zum nächsten Pol 4. Die Platine 3 muss somit nicht den Hauptstrom, beispielsweise in einer Höhe von 200 A, leiten.

### Bezugszeichenliste

- 1: Hochvolt-Energiespeichermodul
- 2: Speicherzellen
- 3: Platine
- 4: Pole
- 5: Laschen
- 6: Verbindungen
- 7: Anschlussverbindung
- 8: Metallelement
- 9: Kabel
- 10: Anschlussvorrichtung
- 11: Bonddrähte
- 12: Zusatzbonddrähte
- 13: Befestigungsstelle
- 14: Temperatursensor
- 15: CPU
- 16: Kapillare
- 17: Bondkraft
- 18: Ultraschall

## Patentansprüche

1. Hochvolt-Energiespeichermodul (1) für eine Spannungsversorgung, insbesondere eines Kraftfahrzeugs, umfassend
- zumindest zwei Speicherzellen (2), und
- zumindest eine elektrisch leitende Verbindung (6) zwischen zwei Polen (4) unterschiedlicher Speicherzellen (2),
**dadurch gekennzeichnet, dass** die einzelne Verbindung (6) aus mehreren nebeneinander angeordneten Bonddrähten (11) besteht, und wobei jeder Bonddraht (11) an den beiden Polen (4) mittels Drahtbonden befestigt ist.

2. Hochvolt-Energiespeichermodul nach Anspruch 1, **gekennzeichnet durch** eine Platine (3) mit einer Elektronik zum Überwachen der Speicherzellen (2).

3. Hochvolt-Energiespeichermodul nach Anspruche 2, **dadurch gekennzeichnet, dass** zumindest einer der Bonddrähte (11) zwischen den beiden Polen (4) auf der Platine (3) mittels Drahtbonden befestigt ist.

4. Hochvolt-Energiespeichermodul nach einem der Ansprüche 2 oder 3, **gekennzeichnet durch** zumindest einen Zusatzbonddraht (12), der einen der Pole (4) mit der Platine (3) verbindet, der auf dem Pol (4) und auf der Platine (3) mittels Drahtbonden befestigt ist, und der auf der Platine (3) endet.

5. Hochvolt-Energiespeichermodul nach einem der Ansprüche 3 oder 4, **dadurch gekennzeichnet, dass** an einer Befestigungsstelle (13) des Bonddrahtes (11) oder des Zusatzbonddrahtes (12) mit der Platine (3) ein Temperatursensor (14) auf der Platine (3) angeordnet ist, der dazu ausgebildet ist, die über den Bonddraht (11) oder Zusatzbonddraht (12) weitergeleitete Temperatur der Speicherzelle (2) zu bestimmen.

6. Hochvolt-Energiespeichermodul nach einem der Ansprüche 2 bis 5, **dadurch gekennzeichnet, dass** alle Pole (4) der Speicherzellen (2) zu einer Seite des Hochvolt-Energiespeichermoduls (1) ausgerichtet sind, wobei auf dieser Seite die Platine (3) aufliegt.

7. Hochvolt-Energiespeichermodul nach einem der Ansprüche 2 bis 6, ferner umfassend
- ein auf der Platine (3) angeordnetes Metallelement (8), vorzugsweise eine Aluminiumplatte, mit einer Anschlussvorrichtung (10) für ein Kabel (9), und
- eine elektrisch leitende Anschlussverbindung (7) zwischen einem Pol (4) einer Speicherzelle (2) und dem Metallelement (8),
- wobei die Anschlussverbindung (7) aus mehreren nebeneinander angeordneten Bonddrähten (11) besteht, und wobei jeder Bonddraht (11) an dem Pol (4) und an dem Metallelement (8) mittels Drahtbonden befestigt ist.

8. Hochvolt-Energiespeichermodul nach einem der vorhergehenden Ansprüche, **dadurch gekennzeichnet, dass**
- die Bonddrähte (11) einen runden Querschnitt mit einem Durchmesser von maximal 1 mm, vorzugsweise maximal 500 µm, aufweisen, oder
- dass die Bonddrähte (11) bandförmig sind mit einer Breite von maximal 3 mm, vorzugsweise maximal 2 mm.

9. Verfahren zur Herstellung eines Hochvolt-Energiespeichermoduls (1) zur Spannungsversorgung, insbesondere eines Kraftfahrzeugs, umfassend die folgenden Schritte:
- Bereitstellen zumindest zweier Speicherzellen (2), und
- Ausbilden zumindest einer elektrisch leitenden Verbindung (6) zwischen zwei Polen (4) unterschiedlicher Speicherzellen (2),
**dadurch gekennzeichnet, dass** für die einzelne Verbindung (6) mehrere Bonddrähte (11) jeweils mit beiden Polen (4) drahtgebondet werden.

10. Verfahren nach Anspruch 9, **dadurch gekennzeichnet, dass** beim Drahtbonden der Bonddraht (11) durch Aufbringen von Druck .und/oder Ultraschall und/oder erhöhter Temperatur mit dem jeweiligen Pol (4), mit dem Metallelement (8) oder mit der Platine (3) verbunden wird.

## Claims

1. A high-voltage energy storage module (1) for a voltage supply, especially of a motor vehicle, comprising
- at least two storage cells (2), and
- at least one electrically conductive connection (6) between two poles (4) of different storage cells (2),
**characterised in that** the single connection (6) comprises a plurality of adjacently arranged bonding wires (11), and wherein each bonding wire (11) is attached to the two poles (4) by wire bonding.

2. A high-voltage energy storage module according to claim 1, **characterised by** a circuit board (3) with electronics for monitoring the storage cells (2).

3. A high-voltage energy storage module according to claim 2, **characterised in that** at least one of the bonding wires (11) is attached to the circuit board (3) between the two poles (4) by wire bonding.

4. A high-voltage energy storage module according to either one of claims 2 or 3, **characterised by** at least one additional bonding wire (12), which connects one of the poles (4) to the circuit board (3), is attached to the pole (4) and to the circuit board (3) by wire bonding and ends on the circuit board (3).

5. A high-voltage energy storage module according to either one of claims 3 or 4, **characterised in that** arranged on the circuit board (3) at an attachment point (13) of the bonding wire (11) or of the additional bonding wire (12) with the circuit board (3) is a temperature sensor (14) which is configured to determine the temperature of the storage cell (2), which temperature is relayed by the bonding wire (11) or by the additional bonding wire (12).

6. A high-voltage energy storage module according to any one of claims 2 to 5, **characterised in that** all the poles (4) of the storage cells (2) are oriented towards one side of the high-voltage energy storage module (1), the circuit board (3) resting on this side.

7. A high-voltage energy storage module according to any one of claims 2 to 6, further comprising
- a metal element (8), preferably an aluminium plate, which is arranged on the circuit board (3), with a connection device (10) for a cable (9), and
- an electrically conductive connection (7) between one pole (4) of a storage cell (2) and the metal element (8),
- wherein the connection (7) comprises a plurality of adjacently arranged bonding wires (11), and wherein each bonding wire (11) is attached to the pole (4) and to the metal element (8) by wire bonding.

8. A high-voltage energy storage module according to any one of the preceding claims, **characterised in that**
- the bonding wires (11) have a round cross section with a diameter of at most 1 mm, preferably at most 500 µm, or
- **in that** the bonding wires (11) are strip-shaped with a width of at most 3 mm, preferably at most 2 mm.

9. A method for producing a high-voltage energy storage module (1) for the voltage supply, especially of a motor vehicle, comprising the following steps:
- providing at least two storage cells (2), and
- forming at least one electrically conductive connection (6) between two poles (4) of different storage cells (2),
**characterised in that** a plurality of bonding wires (11) are respectively wire-bonded with both poles (4) for the single connection (6).

10. A method according to claim 9, **characterised in that** during the wire-bonding procedure, the bonding wire (11) is connected to the respective pole (4), to the metal element (8) or to the circuit board (3) by applying pressure and/or ultrasound and/or elevated temperature.

## Revendications

1. Module accumulateur d'énergie à haute-tension (1) destiné à une alimentation en tension en particulier d'un véhicule comprenant :
- au moins deux cellules accumulatrices (2), et
- au moins une connexion électriquement conductrice (6) entre deux pôles (4) de différentes cellules accumulatrices (2),
**caractérisé en ce que**
la connexion (6) est constituée de plusieurs fils de liaison (11) situés côte à côte et chaque fil de liaison (11) est fixé aux deux pôles (4) par câblage filaire.

2. Module accumulateur d'énergie à haute-tension conforme à la revendication 1,
**caractérisé par**
une platine (3) équipée d'une électronique permettant de surveiller les cellules accumulatrices (2).

3. Module accumulateur d'énergie à haute-tension conforme à la revendication 2,
**caractérisé en ce qu'**
au moins l'un des fils de liaison (11) est fixé entre les deux pôles (4), sur la platine (3) par câblage filaire.

4. Module accumulateur d'énergie à haute-tension conforme à l'une des revendications 2 et 3,
**caractérisé par**
au moins un fil de liaison supplémentaire (12) qui relie l'un des pôles (4) à la platine (3), qui est fixé sur le pôle (4) et sur la platine (3) par câblage filaire et se termine sur la platine (3).

5. Module accumulateur d'énergie à haute-tension conforme à l'une des revendications 3 et 4,
**caractérisé en ce qu'**
au niveau d'un emplacement de fixation (13) du fil de liaison (11) ou du fil de liaison supplémentaire (12), avec la platine (3) est installé, sur la platine (3), un capteur de température (14) qui est réalisé pour permettre de déterminer la température de la cellule accumulatrice (2) transmise par le fil de liaison (11) ou le fil de liaison supplémentaire (12).

6. Module accumulateur d'énergie à haute-tension conforme à l'une des revendications 2 à 5,
**caractérisé en ce que**
tous les pôles (4) des cellules accumulatrices (2) sont orientés vers une face du module accumulateur d'énergie à haute-tension (1), la platine (3) s'appliquant sur cette face.

7. Module accumulateur d'énergie à haute-tension conforme à l'une des revendications 2 à 6,
comprenant en outre :
- un élément métallique (8) de préférence une plaque d'aluminium installée sur la platine (3) et comprenant un dispositif de connexion (10) d'un câble (9), et
- une connexion électriquement conductrice (7) entre un pôle (4) d'une cellule accumulatrice (2) et l'élément mécanique (8),
- la connexion (7) étant constituée de plusieurs fils de liaison (11) installés côte à côte et chaque fil de liaison (11) étant fixé au pôle (4) et à l'élément métallique (8) par câblage filaire.

8. Module accumulateur d'énergie à haute-tension conforme à l'une des revendications précédentes,
**caractérisé en ce que**
- les fils de liaison (11) ont une section ronde avec un diamètre maximum de 1 mm, et de préférence un diamètre maximum de 500 µm, ou
- les fils de liaison (11) sont en forme de bande et ont une largeur maximum de 3 mm, de préférence une largeur maximum de 2 mm.

9. Procédé de fabrication d'un module accumulateur d'énergie à haute-tension (1) pour permettre l'alimentation en tension en particulier d'un véhicule comprenant les étapes suivantes consistant à :
- se procurer au moins deux cellules accumulatrices (2), et
- former au moins une connexion électriquement conductrice (6) entre deux pôles (4) de différentes cellules accumulatrices (2),
**caractérisé en ce que**
pour obtenir la connexion (6), plusieurs fils de liaison (11) sont respectivement liés par câblage filaire avec les deux pôles (4).

10. Procédé conforme à la revendication 9,
**caractérisé en ce que**
lors du câblage filaire, le fil de liaison (11) est lié au le pôle (4) respectif, à l'élément métallique (8) ou à la platine (3) par application de pression et/ou d'ultrasons et/ou d'une température élevée.
